# EUROPEAN PATENT APPLICATION

(11) **EP 2 393 115 A1**
(43) Date of publication of application: **07.12.2011**
(21) Application number: 10251033.6
(22) Date of filing: 03.06.2010
(51) Int. Cl.: H01L 27/115, H01L 21/8247, G11C 16/04, H01L 21/336, H01L 29/788, H01L 21/265

(54) **Memory cell**

(71) Applicant: NXP B.V., 5656 AG Eindhoven (NL)
(72) Inventor: Boter, Johan Dick, Redhill, Surrey RH1 1DL (GB); Tao, Guoqiao, Redhill, Surrey RH1 1DL (GB); Dormans, Guido Jozef Maria, Redhill, Surrey RH1 1DL (GB); Garbe, Joachim Christoph Hans, Redhill, Surrey RH1 1DL (GB)
(74) Representative: Burton, Nick

(57) **Abstract**

A non-volatile memory cell (200) comprising a floating gate transistor (206) comprising a floating gate (10) positioned between a control gate (14) and a first channel region (232) and an access gate transistor (208) comprising an access gate (22) and a second channel region (234), the first channel region (232) comprising a first implant (242) with a first dosage level (234), and the second channel region comprising a second implant (244) having a second dosage level, the first dosage level being less than the second dosage level.

## Description

This invention relates to a non-volatile memory cell comprising a floating gate transistor and an access gate transistor, and to a method of manufacturing such a non-volatile memory cell.

Non-volatile memories (NVMs) are used in a wide variety of electronic devices and equipment NVMs are becoming particularly important components of portable electronic equipment such as mobile phones, radios and digital cameras. It is important that such devices have as low an operating voltage as possible, typically less then 1.8V, have low power consumption and require a chip size of a few mm² or less.

A known non-volatile memory cell comprises a MOSFET with a floating gate (FG) positioned between a control gate (CG) and a channel region. The floating gate and the control gate are separated by a dielectric layer. Such a device is known as a Flash or FFPPROM cell in which electrons or holes are injected into a floating gate e.g. by means of iunnelling through an oxide barrier known as the tunnel oxide- Charges stored in the FG modify the threshold voltage of the device.

It is known to use access gate (AG) transistors in such non-volatile memories, for example to isolate adjacent cells forming a memory array. An access gate transistor can also be used to allow the non-volatile cell to have a negative threshold voltage. This means that there can be no over-erase, which allows the cell to be read at a gate voltage dose to ground. In addition the cell can be programmed and erased by Fowler-Nordheim tunnelling to and from the channel region, and disturbances of the cells during programming and erasing can be avoided. A relatively compact 2T cell can be made by treating the AG as a floating gate cell. This means that the AG can be readily processed with the FG and may have the same stacked gate configuration as the FG cell but with a contacted FG.

The channel region of a non-volatile memory cell is formed in a well. The well may comprise a threshold voltage (Vt) implant which comprises ions that have been implanted into the channel region to influence the threshold voltage of the cell.

In a known memory cell, both the access gate transistor and the floating gate transistor share the same Vt implant, and thus the threshold voltage of both the access gate transistor and the floating gate transistor is, at least in part, determined by a single implant.

In order to distinguish between the 0 state and the 1 state of the memory cell, it is important that the threshold voltages of the floating gate transistor in both states are sufficiently different to one another so that a reading voltage may be selected between the threshold voltage in the 0 state and the threshold voltage in the 1 state to ensure that the cell is correctly read.

The 0 state of the memory cell is the conducting state, and is the most critical state.

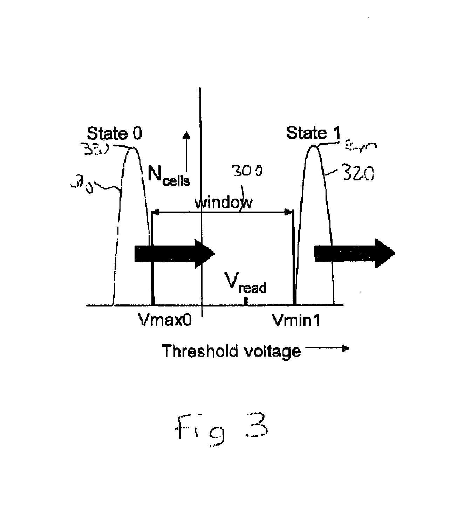

Figure 3 shows graphically how the threshold voltages of individual memory cells forming a memory array vary during use. In particular. Figure 3 shows the distribution of the threshold voltages of memory cells in both the conducting state which is represented by curve 310, and in the non-conducting state which is represented by curve 320.

Due to natural variations between individual cells, not all cells in a memory array have the same threshold voltage and this is why there is a distribution of threshold voltages as shown in Figure 3. In general, the threshold voltages of memory cells forming memory array will tend to have a Gaussian distribution. The threshold voltages will thus have an average value, a distribution width and maximum and minimum values.

The vertical axis of the graph shown in Figure 3 indicates the number of cells having a given threshold voltages. The peak 330, 340 of each curve 310, 320 respectively represents the average value of the threshold voltage distribution in the conducting state and the non-conducting state respectively.

Considering curve 310 which represents the distribution of threshold voltages of cells in the 0 state, the voltage Vₘₐₓ₀ represents the threshold voltage of the weakest cell or cells in the array. Similarly, corsidering curve 320, the voltage Vₘᵢₙ₁ represents the threshold voltage of the weakest cell or cells in the array in the 1 state.

The difference between Vₘₐₓ₀ and Vₘᵢₙ₁ is known as the operating window 300.

As shown in Figure 3. a read voltage V_{read} may be chosen which falls between the threshold voltages of the cells in the conducting state, and the threshold voltages of the cells in the non-conducting state. The difference between a threshold **voltage** of a cell and Vᵣead is known as the read margin.

Vₘₐₓ₀ indicates the smallest threshold voltage margin, or read margin with respect to the read voltage V_{read} when the cells are in the conducting state. Similarly, Vₘᵢₙ₁ indicates the smallest threshold voltage margin, or read margin when the cells are in the non-conducting state.

Due to the fact that the cells wear out through the write/erase operation cycling, the threshold voltages increase (i.e. become more positive) during use. This means that through cycling, the read margin in the conducting state (V_{read} - Vₘₐₓ₀) will decrease until it becomes so small that the cell is no longer readable. At that point the cell will fail.

As shown in Figure 3, the read voltages V_{read} is not necessarily selected to be at the mid point between the threshold voltages in the conducting and non-conducting states. V_{read} is usually fixed, and the threshold voltage of the state 0, and state 1 of each memory cell can be manipulated by modifying the operating voltages that are used to change the number of electrons in the floating gate of Each cell.

The size of the operating window 300, which is initial margin V_{read} - Vₘₐₓ₀ required to read the memory cell can be increased by increasing the program and erase voltages. However, the size of the window is limited by the maximum high voltages available due to the operating limitations of the cells.

According to a first aspect of the present invention there is provided a non-volatile memory cell comprising a floating gate transistor comprising a floating gate positioned between a control gate and a first channel region, and an access gate transistor comprising an access gate and a second channel region, the first channel region comprising a first implant with a first dosage level, and the second channel region comprising a second implant having a second dosage level, the first dosage level being less than the second dosage level.

According to a second aspect of the present invention there is provided a memory array comprising a plurality of non-volatile memory cells, each cell comprising a floating gate transistor comprising a floating gate positioned between a control gate and a first channel region, and an access gate transistor comprising an access gate and a second channel region, the first channel region comprising a first implant, having a first dosage level, and the second channel region comprising a second implant having a second dosage level, the first dosage level being less than the second dosage level.

The first and second channel regions may be formed within a common well- The common well may be formed within a silicon substrate.

It is possible to achieve a large operating window in a non-volatile cell by ensuring a good separation between the threshold voltage of the cell in the 0 state and that of the cell in the 1 state.

Further, when the cell forms part of a memory array comprising a plurality of cells a large operating window may be achieved by minimising the spread of voltages around the average values.

The spread of voltages in a memory cell comprising a plurality of cell is partly caused by the uncertainty in the number of active doping atoms (N) in the depletion layer of each floating gate transistor in the array. The smaller the number N, the smaller will be the distribution of threshold voltages. This means that the spread of threshold voltages may be reduced by ensuring that a smaller dose is implanted into the semiconductor substrate.

From the point of view of a floating gate transistor therefore, it is advantageous to have an implant with a low dose.

On the other hand, it is advantageous to ensure that the dose of the implant of the access gate is sufficiently high in order to ensure that the access gate is isolated from the floating gate.

By means of the present invention, it is possible for the dosage levels of the implants of both the floating gate transistor and the access gate transistor to be optimised in order to maximise the performance of the memory cell.

In addition, the spread of voltages in a memory array according to the second aspect of the invention can be reduced by reducing the implant dosage level of the first implant in each cell, whilst the access gate ensures that the floating gate remains isolated by maintaining a high implant dosage level in the second implant in each cell.

The inventors have realised that, surprisingly, the voltage threshold of the floating gate transistor forming part of the memory cell according to the invention is critical when determining the reliability of the memory cell. The inventors have therefore realised that the reliability of such a memory cell can be improved by ensuring that the implant dosage of the floating gate transistor is kept low, whilst the implant dosage of the access gate is kept high.

The first and second dosage levels may be chosen to suit the application to which the non-volatile memory cell will be put However, in embodiments of the invention, the first dosage level is within the range of 0 to 5e¹¹ cm⁻².

The second dosage level may fall within the range 1e¹² to 5e^{T3} cm⁻²

The first and second implants comprise ions implanted into the common well. When the common well is formed within a silicon substrate, the first and second implants are formed by implanting ions into the silicon substrate.

The ions may comprise any suitable ions such as arsenic, boron, indium, phosphorus or antimony.

The ions in both the first and second implants may be the same species as one another. Alternatively, they may be different species.

The memory cell may comprise a plurality of access gate transistors and/or a plurality of floating gate transistors.

In embodiments of the invention there may be one or two access gate transistors. There may also be one or two floating gate transistors.

According to a third aspect of the present invention there is provided a method of fabricating a non volatile memory cell comprising a floating gate transistor comprising floating gate positioned between a control gate and a first channel region, and an access gate transistor comprising an access gate and a second channel region, the first channel region comprising a first implant having a first dosage level, and the second channel region comprising a second implant having a second dosage level, the first dosage level being less than the second dosage level, the method comprising the steps of implanting ions into a substrate at a first dosage level; masking the substrate to form a masked part and an unmasked part; implanting further ions into the unmasked part to form a region in the substrate having a second dosage level of ions, the second dosage level being higher than the first dosage level to thereby form first and second implants.

The floating gate transistor will be formed on the masked part of the substrate and will thus comprise a first implant having a first dosage level, and the access gate transistor will be formed on the unmasked part of the substrate and will therefore comprise a second implant having a second dosage level.

The method may comprise the further step of unmasking the masked part of the substrate and then growing a tunnel oxide layer on the substrate.

The tunnel oxide layer may be formed from, for example, silicon oxide.

The masked part of the substrate may be masked by depositing a mask layer over a portion of the substrate. This masked layer may be removed after the further ions have been implanted.

The method may comprise the further step of depositing a first conductive layer over the tunnel oxide layer.

Subsequently, the method may comprise the steps of depositing a dielectric layer on the first conductive layer and then depositing a second conductive layer over the dielectric layer.

The first and second conductive layers may comprise any suitable material and may for example each be formed from polysilicon.

Finally, the access gate transistor and the floating gate transistor may be isolated from one another using known etching steps

The invention will now be further described by way of example only with reference to the accompanying drawings in which:
Figure 1 is a schematic representation of a known non-votatile memory cell comprising an access gate transistor and a floating gate transistor,
Figure 2 is a schematic representation of a non-volatile memory cell according to an embodiment of the present invention;
Figure 3 is a graphical representation showing the distribution of threshold voltages for the 0 state and 1 state for the memory cell illustrated in Figure 2;
Figure 4 is a graphical representation showing the distribution of a reference array showing the difference in the spread of threshold voltages for the memory cell illustrated in Figure 2 compared with the memory cell of Figure 1;

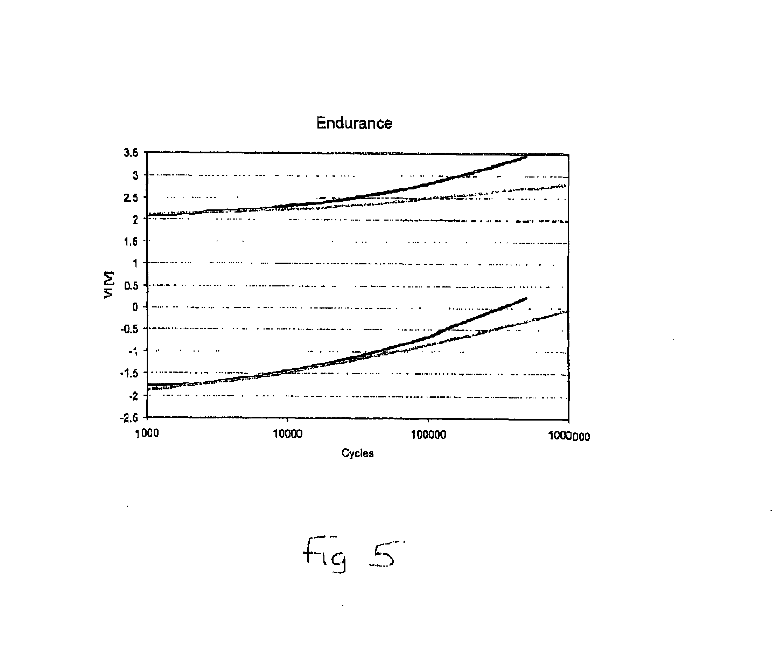

Figure 5 is a graphical representation showing endurance or cycling results for a memory cell illustrated in Figure 2 compared with the memory cell of Figure 1; and
Figure 6 is a graphic representation of showing the time to failure for a cell of the type shown in Figure 2 compared to that of a memory cell of the type shown in Figure 1.

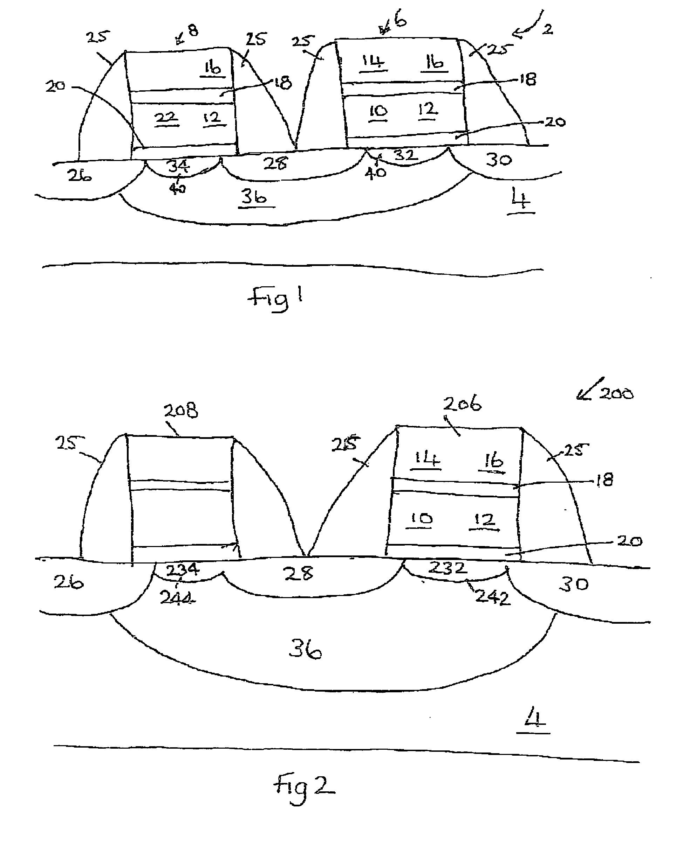

Referring to Figure 1 a known 2T non-volatile memory cell is designated generally by the reference numeral 2. The cell 2 comprises a substrate 4, a floating gate transistor 6 and an access gate transistor 6. The floating gate transistor 6 comprises a floating gate 10 formed from a first conductive layer 12 and a control gate 14 formed from a second conductive layer 16. The floating gate 10 and the control gate 14 are separated from one another by a dielectric layer 18. The floating gate 10 is further separated from the substrate 4 by means of a tunnel oxide layer 20.

The access gate transistor 8 comprises an access gate 22 formed from the first conductive layer 12 which is covered by the dielectric layer 18. In this embodiment the access gate transistor also comprises a further layer 24 formed from the second conductive layer 16. The access gate 22 is isolated from the substrate 4 by the tunnel oxide layer 20. The transistors 6, 8 further comprise side wall spacers 25.

The cell 2 further comprises first diffusion region 26, second diffusion region 28, and third diffusion region 30.

As is known in the art, a diffusion region in a semiconductor substrate may act as either a source or a drain.

In the embodiment shown in Figure 1 the first diffusion region 26 acts as a source to the access gate transistor 8. The second diffusion region 28 acts both as a drain for the access gate transistor 8, and a source for the floating gate transistor 6, and the third diffusion region 24 acts as a drain for the floating gate transistor 6.

As is known in the art, a memory cell of the type illustrated in Figure 1 comprises a first channel region 32 associated with floating gate transistor 6, and a second channel region 34 associated with the access gate transistor 6. The first and second channel regions 32, 34 are formed in a common well 36. It is known to form the well 36 from multiple implants with different dosage and energy. A single implant 40 known as the voltage threshold (Vt) ion implant is implanted into the channel regions 32, 34, and the threshold voltage of the memory device can be altered depending on the dosage of ions implanted.

In the known memory cell 2, the channel regions 32, 34 are formed from the same implant, and therefore have the same implant dosage. The threshold voltage of both transistors 6, 8 will therefore be substantially the same. When reading the cell, the voltage on the AG is higher than its threshold voltage. This means that the threshold voltage of the memory cell is determined by the threshold voltage of the FG, which, in tum, depends on the threshold voltage implant, dose and the amount of charge on the floating gate.

This means that the performance of the cell 22 is compromised because of the differing requirements of the access gate, and the floating gate as explained herein above.

Referring now to Figure 2, a memory cell in accordance with an embodiment of the invention is designated by the reference number 200. Parts of the memory cell 200 that correspond to parts of the known cell 2 illustrated in Figure 1 have been given corresponding reference numerals for ease of reference.

The cell 200 comprises a floating gate transistor 206 and an access gate transistor 208, a first channel region 232 associated with the access gate transistor 208, and a second channel region 234 associated with the floating gate transistor 206.

First channel region 232 associated with the floating gate transistor 206 is formed from a first threshold voltage implant 242, and second channel region 234 associated with the access gate transistor 208 is formed from a second threshold voltage implant 244.

The inventors have realised that by forming the channel regions 232, 234 from different implants, the dosage level of the respective implants 242, 244 may be different. This means, in particular, that the implant 242 may have a lower dosage than the implant 244.

As described herein above, the performance of the memory cell 200 may be improved by having a relatively low implant dosage in respect of the floating gate transistor, and a relatively high implant dosage in respect of the access gate transistor. Typical implant dosage are 1e¹² to 5e¹³ for the AG and 0 to 5e¹¹ cm⁻² for the FG

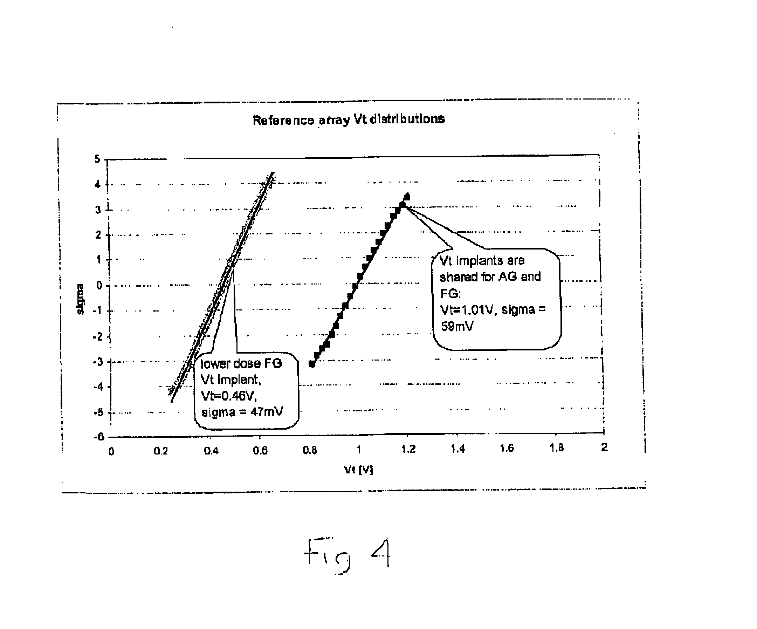

As shown in Figure 4, a lower dosage of implant 244 results in a lower voltage threshold and a lower spread of the voltage threshold of the floating gate transistor 206.

The lower threshold voltage for the floating gate transistor 206 also leads to a greater read margin being created for the state 0 cells as explained hereinabove with respect to Figure 3. Alternatively a shorter erase pulse or a lower erase voltage is needed to bring these cells into state 0.

Further, the degradation of cell current will decrease for the floating gate transistor 206 if a much lower threshold voltage is achieved. This is because a current flowing in the inversion layer of the cell 200 does not pass as close to the interface between the substrate 4 and the gate oxide layer 20 as is the case with higher voltage thresholds. This means that the carrier flow is less affected by the degradation that occurs at the silicon oxide interface. In addition less degradation occurs due to less dopant at this interface.

Further, because of the lower voltage threshold implant dose in the floating gate transistor 206, the memory cell 200 is less sensitive to disturbances to the gate for state 0 cells. When continuously reading a cell with a positive voltage on the control gate the cell experiences a positive voltage stress that may cause the threshold voltage of the conducting cell to increase. This causes the read margin to decrease until, eventually the cell may fail.

Previously, because a single implant had been used for both the access gate transistor and the floating gate transistor, the level of doping was generally determined by the requirements of the access gate transistor. This lead to the problems identified hereinabove.

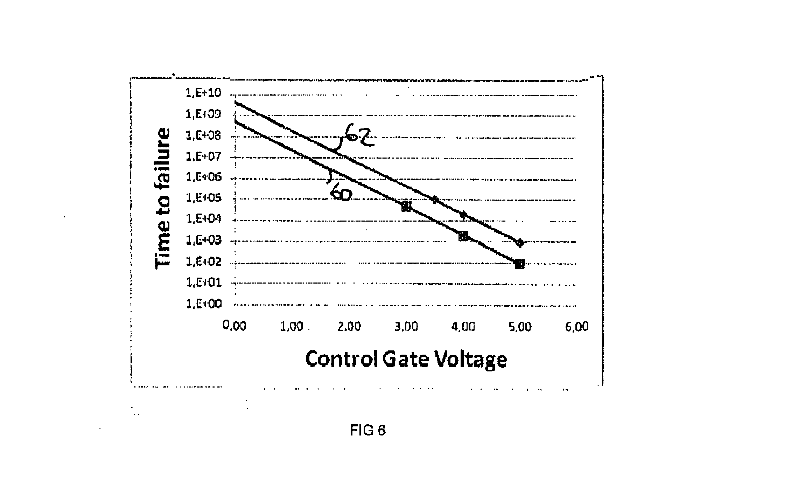

Referring to Figure 6. the time to failure of both a known cell type shown in Figure 1, and a cell according to the present invention as shown in Figure 2 is shown graphically. The line 60 represents the time to failure for cell 2 shown in Figure 1, whilst the line 62 represents the time to failure for the cell 200 according to an embodiment of the invention.

It can be seen from Figure 6 that a cell according to an embodiment of the invention fails approximately one order of time after a known cell of the type shown in Figure 1 for any given control gate voltage.

## Claims

1. A non-volatile memory cell (200) comprising a floating gate transistor (206) comprising a floating gate (10) positioned between a control gate (14) and a first channel region (232) and an access gate transistor (208) comprising an access gate (22) and a second channel region (234), the first channel region (232) comprising a first implant (242) with a first dosage level (234), and the second channel region comprising a second implant (244) having a second dosage level, the first dosage level being less than the second dosage level.

2. A non-volatile memory cell (200) according to Claim 1 wherein the first (232) and second (234) channel regions are formed within a common well (36).

3. A non-volatile memory cell (200) according to Claim 1 or Claim 2 wherein the first dosage level is in the range of 0 to 5e¹¹ cm⁻²_{.}

4. A non-volatile memory cell (200) according to any one of the preceding claims wherein the second dosage level is within the range 1e¹² to 5e¹³ cm⁻².

5. A non-volatile memory cell (200) according to any one of the preceding claims wherein the first (242) and second (244) implants are the same species as one another.

6. A non-volatile memory cell (200) according to any one of the preceding claims comprising a plurality of access gate transistors (208) and/or a plurality of floating gate transistors (206).

7. A memory array comprising a plurality of non-volatile memory cells (200) according to any one of the preceding claims

8. A method of fabricating a non volatile memory cell (200) comprising a floating gate transistor (206) comprising floating gate positioned between a control gate and a first channel region, and an access gate transistor (208) comprising an access gate and a second channel region, the first channel region comprising a first implant having a first dosage level, and the second channel region comprising a second implant having a second dosage level, the first dosage level being less than the second dosage level, the method comprising the steps of implanting ions into a substrate at a first dosage level;
masking the substrate to form a masked part and an unmasked part; implanting further ions into the unmasked part to form a region in the substrate having a second dosage level of ions, the second dosage level being higher than the first dosage level to thereby form first and second implants.

9. A method according to Claim 8 comprising the further step of unmasking the masked part of the substrate and then growing a tunnel oxide layer on the substrate.

10. A method according to Claim 8 or Claim 9 wherein the step of masking the substrate to form a masked part and an unmasked part comprises the step of depositing a masked layer over a portion of the substrate.

11. A method according to any one of Claims 8 to 10 comprising the further step of depositing a first conductive layer over the tunnel oxide layer.

12. A method according to Claim 11 comprising the further step of depositing a dielectric layer on the first conductive layer, then depositing a second conductive layer over the dielectric layer.

## Amended claims

### Amended claims in accordance with Rule 137(2) EPC.

**1.** A non-volatile memory cell (200) comprising a floating gate transistor (206) comprising a floating gate (10) positioned between a control gate (14) and a first channel region (232) and an access gate transistor (208) comprising an access gate (22) and a second channel region (234), the first channel region (232) comprising a first implant (242) with a first dosage level (234), and the second channel region comprising a second implant (244) having a second dosage level, the first dosage level being less than the second dosage level, wherein the first dosage level is in the range of 0 to 5e¹¹ cm⁻²

**2.** A non-volatile memory cell (200) according to Claim 1 wherein the first (232) and second (234) channel regions are formed within a common well* (36).

**3.** A non-volatile memory cell (200) according to Claim 1 or Claim 2 wherein the second dosage level is within the range 1e¹² to 5e¹³ cm⁻².

**4.** A non-volatile memory cell (200) according to any one of the preceding claims wherein the first (242) and second (244) implants are the same species as one another.

**5.** A non-volatile memory cell (200) according to any one of the preceding claims comprising a plurality of access gate transistors (208) and/or a plurality of floating gate transistors (206).

**6.** A memory array comprising a plurality of non-volatile memory cells (200) according to any one of the preceding claims.

**7.** A method of fabricating a non volatile memory cell (200) comprising a floating gate transistor (206) comprising floating gate positioned between a control gate and a first channel region, and an access gate transistor (208) comprising an access gate and a second channel region, the first channel region comprising a first implant having a first dosage level, and the second channel region comprising a second implant having a second dosage level, the first dosage level being less than the second dosage level, the method comprising the steps of implanting ions into a substrate at a first dosage level within the range of 0 to 5e¹¹ cm⁻²; masking the substrate to form a masked part and an unmasked part; implanting further ions into the unmasked part to form a region in the substrate having a second dosage level of ions, the second dosage level being higher than the first dosage level to thereby form first and second implants.

**8.** A method according to Claim 7 comprising the further step of unmasking the masked part of the substrate and then growing a tunnel oxide layer on the substrate.

**9.** A method according to Claim 7 or Claim 8 wherein the step of masking the substrate to form a masked part and an unmasked part comprises the step of depositing a masked layer over a portion of the substrate.

**10.** A method according to Claims 8 or Claim 9 comprising the further step of depositing a first conductive layer over the tunnel oxide layer.

**11.** A method according to Claim 10 comprising the further step of depositing a dielectric layer on the first conductive layer, then depositing a second conductive layer over the dielectric layer.
